# EUROPEAN PATENT APPLICATION

(11) **EP 2 061 049 A2**
(43) Date of publication of application: **20.05.2009**
(21) Application number: 08166072.2
(22) Date of filing: 08.10.2008
(51) Int. Cl.: H01G 9/20

(54) **Dye-sensitized solar cell including anode porous conductive layer**

(30) Priority: 19.11.2007 KR 20070118064
(71) Applicant: Electronics and Telecommunications Research Institute, Daejeon-city 305-350 (KR)
(72) Inventor: Pak, Hunkyun, Daejeon-city (KR); Lee, Seungyup, Gyeongsangbuk-Do (KR); Kang, Mangu, Daejeon-city (KR); Jun, Yong Seok, Daejeon-City (KR); Yun, Hogyeong, Seoul (KR); Park, Jong Hyeok, Daejeon-city (KR); Kim, Jong Dae, Daejeon-city (KR)
(74) Representative: Betten & Resch

(57) **Abstract**

A dye-sensitized solar cell having improved energy conversion efficiency is provided. The dye-sensitized solar cell includes a first electrode and a second electrode facing each other, and an electrolyte layer interposed between the first electrode and the second electrode, wherein the first electrode includes a transparent porous layer and a layer of semiconductor oxide nanoparticles formed in pores of the transparent porous layer and on a surface of the porous conductive layer facing the second electrode, and dye molecules adsorbed into the nanoparticle semiconductor oxide layer.

## Description

This application claims the priority of Korean Patent Application No. 10-2007-0118064, filed Month November 19, 2007, in the Korean Intellectual Property Office, the disclosure of which is incorporated herein in its entirety by reference.

### BACKGROUND OF THE INVENTION

### 1. Field of the Invention

The present invention relates to a solar cell, and more particularly, to a dye-sensitized solar cell having improved energy conversion efficiency using a new electrode material.

The present invention is based on research conducted by Ministry of Information and Communication of Korea in an attempt to develop new IT source technologies pursuant to Project No. 2006-S-006-02, entitled "Component Modules for Ubiquitous Terminals."

### 2. Description of the Related Art

A dye-sensitized solar cell is a novel solar cell with a lower production cost, suggested by Graetzel et al. of Swiss Federal Institute of Technology in Lausanne in Switzerland in 1991. The dye-sensitized solar cell is based on a photoelectrochemical system comprising photosensitive dye molecules that are capable of generating electron-hole pairs by absorbing visible light, a transition metal oxide which transfers generated electrons, as the main constituent materials, and an electrolyte.

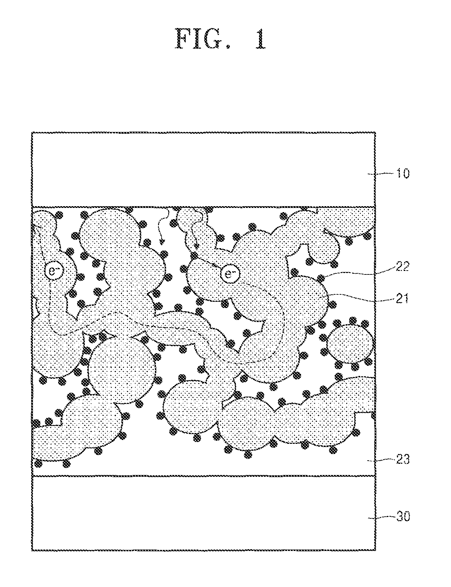

FIG, 1 is a schematic diagram illustrating the operating principle of a general dye-sensitized solar cell. Referring to FIG. 1, sunlight is incident through a transparent electrode (anode) 10 so that photons impinges against dye molecules 22 existing on transition metal semiconductor oxide (TiO₂) 21, which is used as a scaffold for holding many dye molecules as possible per surface area of a given cell in a 3-D medium. The photons impinging against the dye molecules 22 with sufficient energy to be absorbed into the dye molecules 22 so that the dye molecules 22 are excited from a ground state to generate electrons (e-). The electrons (e-) in the excited state are directly injected into the conducting band of the transition metal semiconductor oxide (TiO₂) 21 and are transferred to the electrode 10 by chemical diffusion gradient. On the other hand, the dye molecules 22 oxidized as a result of the transition of electrons is reduced by iodine ions (I) in the electrolyte 23, and the oxidized iodine ions (I₃) are mechanically diffused to a counter electrode 30 to achieve charge neutrality by electrons reaching the counter electrode 30 through an external circuit.

Since the dye-sensitized solar cells can be produced by a simplified process at a low production cost and their energy conversion efficiency is not low compared to conventional silicon solar cells, extensive research into the dye-sensitized solar cells is being conducted.

The photon-to-electron conversion efficiency of dye-sensitized solar cells is considerably high. However, some of the electrons transported to the conducting band of the transition metal semiconductor oxide (TiO₂) 21 may not migrate to the electrode 10 but react with the oxidization/reduction electrolyte to then vanish. In particular, electrons generated on the semiconductor oxide (TiO₂) 21 far from the transparent electrode 10 cannot efficiently reach the conductive layer.

In order to minimize the vanishing electrons, it is desirable to shorten an electron movement path from the dye molecules 22 to the transparent electrode 10. One possible attempt to reduce the electron movement path is to reduce a thickness of a semiconductor oxide layer. However, if the thickness of the semiconductor oxide layer is reduced, the traveling path of sunlight is reduced. Accordingly, the absorption intensity of light is also reduced based on the Beer-Lambert Law. The reduction in the absorption intensity reduces a quantity of electrons generated per unit area. That is to say, increasing the thickness of the semiconductor oxide layer to increase the quantity of electrons generated per unit area and reducing the thickness of the semiconductor oxide layer to reduce the loss of electron migration do not lead to compatible effects. Currently, in a case of using TiO₂ nanoparticles having a particle size in a range of about 15 to about 20 nm, a method of forming a TiO₂ layer having a thickness in a range of about 10 to about 20 µm is widely employed.

Meanwhile, in order to increase light utilization, there has been proposed a method of forming a light scattering layer in rear of a semiconductor oxide layer to scatter the light transmitted out of incident light for recycling, as described in Advanced Materials 2006, 18, 1202-1205. However, the proposed method cannot solve the problem associated with the loss of electrons during an electron transfer process within the semiconductor oxide layer.

### SUMMARY OF THE INVENTION

The present invention provides a dye-sensitized solar cell having improved energy conversion efficiency by reducing a distance between a semiconductor oxide layer and an electrode to achieve efficient electron transfer while increasing the quantity of semiconductor oxide to which dye particles are adsorbed to increase the light absorption per unit area quantity of light.

According to one aspect of the present invention, there is provided a dye-sensitized solar cell including a first electrode and a second electrode facing each other, and an electrolyte layer interposed between the first electrode and the second electrode, wherein the first electrode includes a transparent porous conductive layer and a layer of semiconductor oxide nanoparticles formed in pores of the transparent porous conductive layer and on a surface of the porous conductive layer facing the second electrode, and dye molecules adsorbed into the nanoparticle semiconductor oxide layer.

The porous conductive layer may include a porous glass material doped with a conductive material. The material doped into the porous conductive layer may contain tin (Sn). The porous conductive layer may include a conductive polymer.

The pores formed in the porous conductive layer have a pore size large enough to scatter light to allow the scattered light to reenter the semiconductor oxide nanoparticles. The pores formed in the porous conductive layer may have a mean pore size of 1 micrometer to 1 millimeter. The pores of the porous conductive layer may be interconnected.

The nanoparticle semiconductor oxide layer may include titanium oxide (TiO₂), zinc oxide (ZnO), or niobium oxide (Nb₂O₅).

The dye molecules may include a ruthenium (Ru) complex. In addition, the dye molecules may include an organic material containing thiopente, phthalocyanine, porphyrin, indoline, quinoline and derivatives thereof.

The second electrode may include a conductive substrate coated with platinum (Pt) layer. The second electrode may include a conductive substrate coated with a carbon nanotube layer. The conductive substrate may contain about 95% to about 100% by weight of carbon. The conductive substrate may contain iron (Fe), aluminum (AI), titanium (Ti), nickel (Ni), copper (Cu), or tin (Sn). The second electrode may include a polymer material coated or deposited with a conductive material. The polymer material may include polyethylene terephthalate, polycarbonate, polyimide, polyethylene naphthalate, polyether sulfone, polyethylene or polypropylene.

Optionally, the dye-sensitized solar cell may further include an insulation membrane or a semiconductor film in the electrolyte layer disposed between the first electrode and the second electrode, which allows ion penetration trough the membrane or film.

The electrolyte layer may be in contact with the semiconductor oxide nanoparticles in the pores of the porous conductive layer. The electrolyte may be in a liquid phase at room temperature.

The dye-sensitized solar cell may further include a transparent layer on the porous conductive layer.

### BRIEF DESCRIPTION OF THE DRAWINGS

The above aspect and advantages of the present invention will become more apparent by describing in detail preferred embodiments thereof with reference to the attached drawings in which:
FIG. 1 is a schematic diagram illustrating the operating principle of a general dye-sensitized solar cell;
FIG. 2 is a schematic diagram illustrating the electrode structure of a dye-sensitized solar cell according to an aspect of the present invention;
FIG. 3 is an enlarged view of a portion of a semiconductor electrode; and
FIG. 4 is an enlarged view of in the portion of a semiconductor electrode shown in FIG. 3.

### DETAILED DESCRIPTION OF THE INVENTION

The present invention is described more fully hereinafter with reference to the accompanying drawings, in which exemplary embodiments of the present invention are shown. The present invention may, however, be embodied in many different forms and should not be construed as limited to the exemplary embodiments set forth herein. Rather, these exemplary embodiments are provided so that this disclosure will be thorough and complete, and will fully convey the scope of the invention to those skilled in the art. In the drawings, the size and relative sizes of layers and regions may be exaggerated for clarity. Like reference numerals refer to like elements throughout the specification.

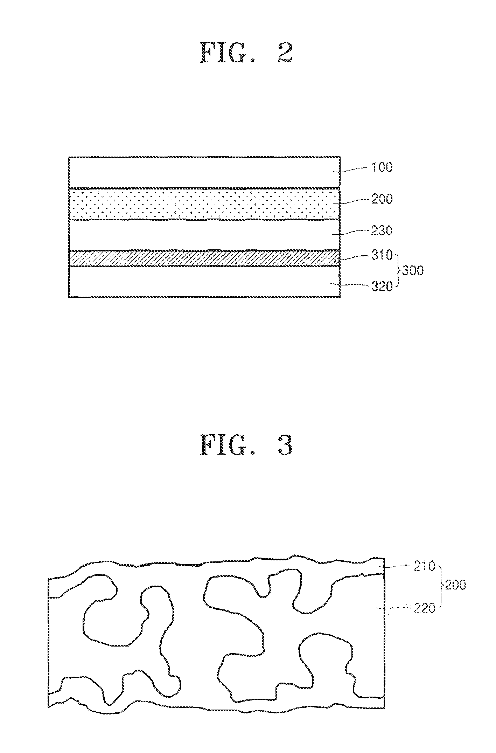

FIG. 2 is a schematic diagram illustrating the electrode structure of a dye-sensitized solar cell according to an aspect of the present invention.

Referring to FIG. 2, the dye-sensitized solar cell according to the present invention include a semiconductor electrode 200, a counter electrode 300, and a layer of an electrolyte 230 interposed between the semiconductor electrode 200 and the counter electrode 300. A transparent layer 100 is formed on the semiconductor electrode 200. Terminals (not shown) through the dye-sensitized solar cell is connected to an external circuit are provided at the semiconductor electrode 200 and the counter electrode 300. While FIG. 2 shows that the electrolyte layer 230 is discrete from the semiconductor electrode 200, the electrolyte 230 is actually mixed with the semiconductor electrode 200 between pores in the semiconductor electrode 200.

FIG. 3 is an enlarged view of the structure of the semiconductor electrode 200. The semiconductor electrode 200 according to the present invention is constructed such that the nanoparticle semiconductor oxide layer 210 is adsorbed into the porous conductive material 220. That is to say, the nanoparticle semiconductor oxide layer 210 which is formed of oxide nanoparticles having dye materials on their surfaces is provided in on a surface of the porous conductive material 220.

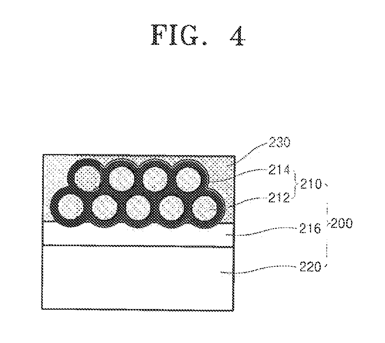

FIG. 4 is an enlarged view of an interfacing portion of the semiconductor oxide layer 210 and the porous conductive material 220. Referring to FIG. 4, a thin metallic oxide layer 216 may be optionally formed on the surface of the porous conductive material 220. The thin metallic oxide layer 216 minimizes recombination of electrons in the electrolyte layer 230 due to a direct contact between porous conductive material 220 and electrolyte layer 230. The thin metallic oxide layer 216 may be made of a transition metal oxide such as TiO2, ZnO, or Nb₂O₅.

Referring again to FIGS. 2, 3 and 4, the dye-sensitized solar cell according to the present invention will be described in detail.

The semiconductor electrode 200 may optionally include the metallic oxide layer 216 on the porous conductive material 220. Semiconductor oxide nanoparticles 212 are attached to the surface of the metallic oxide layer 216 and dye molecules 214 are adsorbed into surfaces of the semiconductor oxide nanoparticles 212. Fine voids between the semiconductor oxide nanoparticles 212 are filled with the electrolyte 230. The semiconductor oxide nanoparticles 212 may be made of a transition metal oxide such as titanium oxide (TiO₂), zinc oxide (ZnO), or niobium oxide (Nb₂O₅). That is to say, components of the semiconductor oxide nanoparticles 212 may be similar to those of the optionally formed layer, that is, the metallic oxide layer 216. However, the semiconductor oxide nanoparticles 212 are different from the metallic oxide layer 216 in that they exist in the form of sintered nanoparticles, rather than in the form of a thin film. The semiconductor oxide nanoparticles 212, the dye molecules 214, the electrolyte 230, and the metallic oxide layer 216 in the form of a thin film constitute a structure filling the voids and surface of the porous conductive material 220, thereby completing the overall structure of the semiconductor electrode 200. Although FIG. 2 shows that the layer of the electrolyte 230 of FIG. 2 is separated from the semiconductor electrode 200, the electrolyte layer is actually contacted to the inside of the semiconductor electrode due to the structure.

The porous conductive material 220 is a conductive layer of the semiconductor electrode 200. The porous conductive material 220 itself may be a conductive material or may be formed by adding a conductive material on a surface of a non-conductive material such as porous glass. For example, the porous conductive material 220 may be formed by doping a conductive material such as tin (Sn) on a surface of porous glass. Alternatively, the porous conductive material 220 may be made of a conductive polymer.

Meanwhile, the porous conductive material 220 is optically transparent material. Pores of the porous conductive material 220 are preferably small enough to maximize a contact area between the porous conductive material 220 and the nanoparticle semiconductor oxide layer 210 and the pores of the porous conductive material 220 are preferably so large that the semiconductor oxide nanoparticles 212 are smoothly filled therein. Considering that the currently widely used semiconductor oxide nanoparticles 212 have a mean particle size in a range of several to several tens of nanometers, the pores of the porous conductive material 220 preferably have a mean pore size in a range of several micrometers to several millimeters. In addition, the pores are preferably interconnected with each other, thereby facilitating movement of nanoparticles when the porous conductive material 220 is filled with the semiconductor oxide nanoparticles 212. Furthermore, since the pores of the porous conductive material 220 serve to scatter light, the light transmitted and scattered is allowed to be recycled, thereby increasing the energy efficiency.

The semiconductor oxide nanoparticles 212 may be made of a transition metal oxide such as titanium oxide (TiO₂), zinc oxide (ZnO), or niobium oxide (Nb₂O₅). The dye molecules 214 may include a ruthenium (Ru) complex. In addition, the dye molecules 214 may include an organic material containing thiopene, phthalocyanine, porphyrin, Indoline, quinoline and derivatives thereof. The electrolyte 230 is formed between the semiconductor electrode 200 and the counter electrode 300. Here, the electrolyte 230 also exists in the pores of the porous conductive material 220 so that it comes into contact with the semiconductor oxide nanoparticles 212 through the dye molecules 214. The electrolyte 230 may be in a solid or gel phase.

The counter electrode 300 may include a conductive substrate 320 coated with platinum (Pt) layer or carbon nanotube layer 310. The conductive substrate 320 may contain carbon (C), iron (Fe), aluminum (AI), titanium (Ti), nickel (Ni), copper (Cu), or tin (Sn). Alternatively, the conductive substrate 320 may include a polymer material coated or deposited with a conductive material. The polymer material may include polyethylene terephthalate, polycarbonate, polyimide, polyethylene naphthalate, polyether sulfone, polyethylene or polypropylene.

Meanwhile, although not shown, an insulation thin film or a semiconductor film may further be provided between the semiconductor electrode 200 and the counter electrode 300. The insulation membrane or the semiconductor film prevents short-circuit between the semiconductor electrode 200 and the counter electrode 300 while it allows ion penetration trough the membrane or film. The transparent layer 100 prevents leakage of the electrolyte 230 in a liquid phase.

The interfacing portion of the semiconductor oxide nanoparticles 212 and the porous conductive material 220, where an electron transfer process occurs, exists not only on the surface of the porous conductive material 220 but also on surfaces of the pores of the porous conductive material 220. Therefore, the quantity of the semiconductor oxide nanoparticles 212 attached to the porous conductive material 220 is greater than that of the conductive substrate shaped of a thin film having the same thickness. Accordingly, the quantity of the dye molecules 214 adsorbed into the semiconductor oxide nanoparticles 212 increases, so that the quantity of sunlight absorbed by the dye molecules 214 is increases, thereby increasing the quantity of electrons generated from the sunlight. In addition, an electron movement path, along which the electrons generated by the dye molecules 214 absorbing the sunlight are transferred to the porous conductive material 220 of the semiconductor electrode 200, is shortened, thereby reducing the loss of electrons during an electron transfer process. Since the absorption of sunlight is increased and the loss of electrons is reduced, the efficiency of the solar cell can be enhanced.

The dye-sensitized solar cell shown in FIG. 2 operates in the following manner. When light, such as sunlight, that is incident through the transparent layer 100 is absorbed into the dye molecules 214 adsorbed into the semiconductor oxide nanoparticles 212 in the porous conductive material 220 of the semiconductor electrode 200. Then, the dye molecules 214 are excited, so that electrons are injected into the conduction bands of the semiconductor oxide nanoparticles 212. The electrons injected into the semiconductor oxide nanoparticles 212 are transferred to the porous conductive material 220 through the interfacing portions of particles. The electrons transferred to the porous conductive material 220 reaches the counter electrode 300 through an external circuit (not shown). Specifically, the electrons transferred to the porous conductive material 220 reaches the Pt layer 310 formed on the counter electrode 300.

Meanwhile, dye molecules oxidized by the transfer of electrons are reduced to their original states using the electrons generated the redox mechanism (3I->^{I}₃⁻⁺2e⁻) of iodine ion in the electrolyte 230. The oxidized iodine ion (13̃∼) reacts with the electrons transferred to the counter electrode 300 to then be reduced again to iodide. In this way, the dye-sensitized solar cell thus operates due to the migration of the electrons.

As described above, the dye-sensitized solar cell according to the present invention uses a conductive porous substrate as a conductive layer of a semiconductor electrode, thereby increasing a contact area with semiconductor oxide nanoparticles. Therefore, the usable quantity of semiconductor oxide nanoparticles is increased, so that utilization efficiency of sunlight is further increased to be absorbed into much more dye molecules, thereby promoting generation of electrons.

As the contact area between the conductive layer and the semiconductor oxide nanoparticles increases, the loss of electrons transferred to the conductive layer can be suppressed. That is to say, the electron generation efficiency and electron transfer efficiency of the dye-sensitized solar cell are increased, thereby markedly improving the energy efficiency of the solar cell.

A solar cell according to an aspect of the present invention will now be specifically explained by way of Example. The Example is given only to illustrate aspects of the present invention, and is not intended to limit the scope of the present invention.

### EXAMPLE

A dye-sensitized solar cell according to an exemplary embodiment of the present invention can be manufactured using a porous glass panel as the conductive substrate 220 provided in the semiconductor electrode 200, the porous glass panel coated with indium tin oxide (ITO) or tin oxide (SnO₂) and having a mean pore size of 10∼100 µm.

The semiconductor oxide nanoparticles 212 provided in pores of the porous glass panel and on a surface of the porous glass panel are formed of titanium dioxide (TiO₂) having a particle size in a range of about 15 to about 25 nm. Dye molecules made of a ruthenium (Ru) complex are chemically adsorbed into a surface of a layer of the semiconductor oxide nanoparticles 212.

The semiconductor electrode 200, including the semiconductor oxide nanoparticles 212 and the conductive layer into which the semiconductor oxide nanoparticles 212 are attached, is surrounded by a solution of iodine-based oxidization/reduction electrolyte 230. The iodine-based oxidization/reduction electrolyte solution may an I₃⁻/I⁻ electrolyte solution, for example, a solution containing 0.7M 1-vinyl-3-methyl-imidazolium iodide and 0.1M Lil(lithium iodide), or an electrolyte solution containing 40 mM iodine (I₂) dissolved in 3-methoxypropionitrile.

The counter electrode 300 may be constructed such that the Pt layer 310 is coated on the conductive substrate 320 coated with ITO or SnO₂, for example, a transparent conductive glass substrate.

As described above, compared to the conventional solar cell, the dye-sensitized solar cell according to the present invention has an electron movement path shortened by increasing a thickness of an incident light absorbing layer while increasing utilization efficiency of sunlight, thereby improving the overall efficiency of the solar cell. In addition, the use of a porous substrate having a wavelength greater than a wavelength of the absorbed light allows the transmitted light to be scattered for recycling, thereby improving the efficiency of the solar cell.

Although the exemplary embodiments of the present invention have been described, it is understood that the present invention should not be limited to these exemplary embodiments but various changes and modifications can be made by one ordinary skilled in the art within the spirit and scope of the present invention as hereinafter claimed.

## Claims

1. A dye-sensitized solar cell comprising:
a first electrode and a second electrode facing each other; and
an electrolyte layer interposed between the first electrode and the second electrode,
wherein the first electrode includes a transparent porous conductive layer and a layer of semiconductor oxide nanoparticles formed in pores of the transparent porous conductive layer and on a surface of the transparent porous conductive layer facing the second electrode, and dye molecules adsorbed into the nanoparticle semiconductor oxide layer.

2. The dye-sensitized solar cell of claim 1, wherein the porous conductive layer includes a porous glass material doped with a conductive material.

3. The dye-sensitized solar cell of claim 2, wherein the material doped into the porous conductive layer contains tin (Sn).

4. The dye-sensitized solar cell of any of the preceding claims, wherein the porous conductive layer comprises a conductive polymer.

5. The dye-sensitized solar cell of any of the preceding claims, wherein the pores formed in the porous conductive layer have a pore size enough to scatter light to allow the scattered light to reenter the semiconductor oxide nanoparticles, preferably a pore size of 1 µm -1 mm.

6. The dye-sensitized solar cell of any of the preceding claims, wherein the pores of the porous conductive layer are interconnected.

7. The dye-sensitized solar cell of any of the preceding claims, wherein the nanoparticle semiconductor oxide layer comprises titanium oxide (TiO₂), zinc oxide (ZnO), or niobium oxide (Nb₂O₅).

8. The dye-sensitized solar cell of any of the preceding claims, wherein the dye molecules comprise a ruthenium (Ru) complex and/or an organic material containing thiopene, phthalocyanine, porphyrin, indoline, quinoline and derivatives thereof.

9. The dye-sensitized solar cell of any of the preceding claims, wherein the second electrode comprises a conductive substrate coated with platinum (Pt) layer and/or coated with a carbon nanotube layer.

10. The dye-sensitized solar cell of claim 9, wherein the conductive substrate contains about 95% to about 100% by weight of carbon, or
wherein the conductive substrate comprises iron (Fe), aluminum (AI), titanium (Ti), nickel (Ni), copper (Cu), or tin (Sn).

11. The dye-sensitized solar cell of any of the preceding claims, wherein the second electrode comprises a polymer material coated or deposited with a conductive material.

12. The dye-sensitized solar cell of claim 11, wherein the polymer material includes polyethylene terephthalate, polycarbonate, polyimide, polyethylene naphthalate, polyether sulfone, polyethylene or polypropylene.

13. The dye-sensitized solar cell of any of the preceding claims, further comprising an insulation thin film or a semiconductor film in the electrolyte layer disposed between the first electrode and the second electrode.

14. The dye-sensitized solar cell of any of the preceding claims, wherein the electrolyte layer is in contact with the semiconductor oxide nanoparticles in the pores of the porous conductive layer.

15. The dye-sensitized solar cell of any of the preceding claims, wherein the electrolyte is in a liquid phase at room temperature, or wherein the electrolyte is in a solid or gel phase at room temperature.

16. The dye-sensitized solar cell of any of the preceding claims, further comprising a transparent layer on the porous conductive layer.

17. The dye-sensitized solar cell of any of the preceding claims, further comprising a metallic oxide layer between the porous conductive layer and the nanoparticle semiconductor oxide layer, wherein preferably the metallic oxide layer comprises titanium dioxide.
